(19)

Europäisches Patentamt

European Patent Office

Office européen des brevets

(11) **EP 4 468 007 A1**

(12) **EUROPEAN PATENT APPLICATION**

(43) Date of publication:
**27.11.2024 Bulletin 2024/48**

(21) Application number: **23305808.0**

(22) Date of filing: **22.05.2023**

(51) International Patent Classification (IPC):
**G01R 33/48** (2006.01)

(52) Cooperative Patent Classification (CPC):
**G01R 33/4824; G01R 33/4826; G01R 33/543; G01R 33/561**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Commissariat à l'Energie Atomique et aux Energies Alternatives
75015 Paris (FR)**

(72) Inventors:
- **CIUCIU, Philippe**
  **91191 GIF-SUR-YVETTE (FR)**
- **GILIYAR RADHAKRISHNA, Chaithya**
  **91191 GIF-SUR YVETTE (FR)**

(74) Representative: **Atout PI Laplace
Immeuble Up On
25 Boulevard Romain Rolland
CS 40072
75685 Paris Cedex 14 (FR)**

(54) **METHOD AND APPARATUS FOR PERFORMING ACCELERATED MAGNETIC RESONANCE IMAGING WITH REDUCED OVERSAMPLING AT LOW SPATIAL FREQUENCIES**

(57) **A method of performing magnetic resonance imaging** of a body using a magnetic resonance imaging scanner the method comprising applying to said body a time-varying magnetic field gradients ($G_x$, $G_y$, $G_z$) defining a continuous trajectory (ST) in k-space complying with a set of constraints including constraints on maximum amplitude and maximum slew rate of said time-varying magnetic field gradients, such that sampling points (KS) belonging to the trajectory define a pseudo-random sampling of the k-space, approximating a predetermined target sampling density, said trajectory in k-space minimizing, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;
characterized in that said trajectory (ST, MT) in k-space defines a Cartesian sampling of a central region (S) of the k-space.

Fig. 4

**Description**

The invention relates to a method and apparatus for performing accelerated magnetic resonance imaging while minimizing the adverse impact of oversampling in the central region of the k-space, i.e. at low spatial frequencies.

Magnetic Resonance Imaging (MRI) is one of the most powerful imaging techniques used in clinical routine today, but remains a lengthy procedure, particularly when the acquisition of large and/or high resolution images, comprising several millions of pixels, is sought. For instance, acquiring a three-dimensional image of a human brain with a field of view of 205x205x52 mm$^3$ and a 200 $\mu$m resolution using a T2* sequence at an acceptable signal-to-noise ratio (SNR) of 7.6 may require an acquisition time of about three hours for a short repetition time (TR=20ms), which is clearly unacceptable for clinical purposes.

This is because MRI images are obtained by sampling the so-called "k-space" domain, the spatial frequency spectrum of the image, which is related to the physical space by a multidimensional Fourier transform. Sampling theory teaches that the sampling frequency should be at least twice the highest frequency contained in the signal to be sampled (which, in the case of MRI, is the multidimensional Fourier transform of the body to be imaged), otherwise aliasing artifacts will appear; this is known as the Nyquist, or Nyquist-Shannon, criterion. As a consequence, using conventional acquisition schemes, the number of k-space samples must be at least equal to the number of pixels of the image to be reconstructed. Moreover, SNR requirements impose a minimum acquisition time for each sample.

Several techniques have been developed in order to reduce the acquisition time while avoiding artifact ("accelerated MRI").

Some of these techniques, such as Simultaneous Multislice Imaging (SMS) and parallel MRI involve the use of specialized hardware comprising multiple receiver coils for acquiring magnetic resonance signals. Their implementation is therefore expensive. Moreover, they provide a limited acceleration, because image quality drops fast with the acceleration factor. Even using both techniques simultaneously, the combined acceleration factor does not exceed 8 in practice.

Other techniques are compatible with the use of a single receiving coil (even though the use of multiple coils is also possible), like Partial Fourier imaging, which exploits redundancies in k-space information, non-Cartesian k-space filling such as radial or spiral and Compressed Sensing (CS). While Partial Fourier techniques only offer very limited acceleration factors (typically lower than two), Compressed Sensing allows higher accelerations especially while imaging with high matrix size (either high resolution and small field of view or low resolution and large field of view), see [Haldar, 2014].

A review of CS MRI can be found in [Lustig et al, 2008].

Compressed Sensing techniques rely on three principles:

- The image to be reconstructed must admit a sparse (or compressible) representation. Said differently, it must be possible to decompose it on a predetermined basis (e.g. a wavelet basis) such that only a small fraction of the decomposition coefficients is non-zero for strict sparsity or significantly greater than zero for compressibility. Typically, in the case of a noisy signal, a coefficient is considered significantly greater than zero if its absolute value is at least equal to the noise standard deviation. Alternatively, only a predetermined fraction of the coefficients - those having the greatest absolute value - may be kept. For instance, only the top 1% of the coefficient may be kept, resulting in a compression factor of 100.
- Reconstruction must be performed using a nonlinear method promoting sparsity of the image representation, as well as consistency with the acquired samples.
- The k-space must be under-sampled, in order to accelerate the acquisition, following a pseudo-random pattern. The undersampling reduces the number of signal acquisitions, and therefore provides the required acceleration, while pseudo-randomness ensures that, in the sparsifying representation, subsampling artifacts are incoherent, i.e. decorrelated or noise-like. This incoherence property is extremely important and measures the degree of correlation between any pair of elements taken in the sparsifying (e.g., wavelets) and sensing (e.g., Fourier in CS-MRI) bases.

Compressed sensing often uses non-Cartesian pseudo-random sampling of k-space since this strategy provides improved incoherence (lower correlation between samples). Preferably, the pseudo-random sampling is non-uniform. This is because

An image decomposition in a sparsifying basis like a wavelet transform consists of approximation and detail coefficients. The approximation coefficients encode low frequency information and thus are not sparse while the detail ones encode high frequency content and are sparse. Sparsity can be imposed to recover the detail coefficients while information (low frequency content) associated with the approximation ones must be collected in the data. Due to this we must adopt a variable density sampling approach that picks up more measurements in the low frequencies as compared to the high frequencies. Another view on that is to say that variable density sampling (VDS) is a theoretical means to minimize the number of collected samples to guarantee exact image reconstruction with high probability. In clinical application, this usually means using a variable sampling density which is highest near the center of the k-space (low spatial frequencies) and decreases toward high spatial frequencies.

From a purely theoretical point of view, the pseudo-random sampling could be obtained by drawing sampling points following a predefined probability distribution, corresponding to the required sampling density. But in practice, the short lifespan of MR signals requires samples to be acquired through segmented acquisitions along smooth trajectories which are defined by time-varying magnetic field gradients applied to the body to be imaged after the excitation of its nuclear spins by a radio-frequency (RF) pulse.

Let $\vec{G}$ represent the magnetic field gradients applied to the body to be imaged. These magnetic field gradients defines a trajectory in the k-space which is expressed by:

$$\overrightarrow{k(t)} = \gamma \cdot \int_0^t \overrightarrow{G(\tau)}\, d\tau$$

$$(1)$$

Sampling is performed by acquiring the MRI signal generated by excited nuclear spins at predetermined times, which correspond to points along said trajectory.

Neither the gradient field amplitude $\|\overrightarrow{G(t)}\|$ nor its slew rate can exceed respective limits Gmax and Smax, due to both hardware and, for clinical applications, physiological constraints. Therefore, only sufficiently regular trajectories are allowed.

These trajectories may be bi-dimensional in 2D MRI, when only nuclear spins within a thin slice of the body are excited, on three-dimensional in 3D MRI techniques, where the excitation concerns the whole body or a thick slab thereof. In the following, for the sake of simplicity, only the case of 2D trajectories will be considered; the invention, however, also applies to 3D and even 4D (i.e. dynamic) MRI.

An important feature of MRI is that the signal decays exponentially after the application of the exciting RF pulse, and typically vanishes. This limits the duration of signal acquisition, and therefore the length of each individual k-space trajectory. As a consequence, several excitation RF pulses, each followed by MRI signal acquisition along a respective elementary trajectory (or "shot"), are required to perform a full k-space sampling. The repetition time TR of these excitation RF pulses - which imposes an upper limit on the duration of the signal acquisition - also depends on the used imaging technique, and in particular on the type of contrast which is sought (T1, T2, T2*...).

Commonly used k-space trajectories are parallel lines (leading to Cartesian sampling), spokes (straight lines radially diverging from the center of the k-space), rosettes, uniform- and variable-density spirals. All of them have been applied to Compressed Sensing, for instance by performing only a limited number of signal acquisitions over a Cartesian grid or by randomly sampling spokes, spirals or rosettes.

Better results, however, are achieved by using "non-parametric" trajectories that provide larger incoherence.

In particular, the so-called SPARKLING ("Spreading Projection Algorithm for Rapid K-space sampLING") technique ([Boyer et al, 2016], [Lazarus et al. 2017], [Lazarus et al. 2019], [Chaithya et al. 2022], WO2019/048565) is based on the projection of a predetermined, usually non-uniform, Target Sampling Distribution (TSD) onto the set of "admissible" 2D or 3D curves, i.e. to all the curves representing trajectories obtainable without exceeding the limits on the values of the magnetic field gradients and the corresponding slew rate.

A drawback of some non-Cartesian MRI sampling schemes, such as SPARKLING, is that they vastly oversample the central part of the k-space, at a rate much higher than the Nyquist rate - sometimes up to 20 k-space samples per Nyquist voxel on average. Indeed, while high-spatial frequency components ("detail", in a wavelet decomposition) can be undersampled and then recovered by sparsity constraints - and this is indeed at the heart of CS-MRI - low-spatial frequencies ("approximation" in a wavelet decomposition) must be fully sampled to ensure perfect recovery. However, in most non-Cartesian CS-MRI implementation, including SPARKLING, every shot is constrained to pass through the center of the k-space at the Echo time TE (Echo Time constraint, see [Chauffert et al. 2016]), notably in order to have a good target contrast and to allow the correction of motion artifacts, leading to oversampling, which is disadvantageous for at least two reasons. On the one hand, these extra k-space samples could be used to sample higher frequencies instead. On the other hand, as the k-space data are acquired as integration over different k-space trajectories, such repeated sampling of the same Nyquist voxel by trajectories of different paths can lead to accumulation of $B_0$ artifacts.

A partial solution of this problem is to update the TSD by taking the TE constraint into account and reducing the density around the center of the k-space to limit the number of samples per Cartesian k-space voxel. This, however, does not fully mitigate the problem, as several samples (one per shot) are still present at the center of k-space causing nearby regions to be sampled densely.

Even if the Echo Time constraint is removed (which is possible for sufficiently low scan times, albeit at the cost of a reduction of target contrast), oversampling can still occur if the shots are stuck in local minima. Furthermore, removing the Echo Time constraint can lead to sampling the center of k-space at different times, thereby destroying contrast and

increasing $B_0$ artifacts.

The invention aims at overcoming, in full or in part, the above-mentioned drawback of the prior art. More particularly, it aims at providing a method of accelerated MRI ensuring that the central part of the k-space is sampled at or near the Nyquist criterion, avoiding both oversampling and undersampling.

According to the invention, this aim is achieved by modifying SPARKLING trajectories by introducing suitable affine constraints to ensure a substantially Cartesian sampling of a central region of the k-space. This approach will be called GoLF-SPARKLING as it stands for Gridding of Low Frequency (GoLF) SPARKLING.

An object of the invention is then a method of performing magnetic resonance imaging of a body using a magnetic resonance imaging scanner comprising a scanner bore, a primary coil, radio frequency coils, gradient coils) and a signal-processing unit, the method comprising the steps of:

a. positioning the body in a scanner bore where a static and substantially uniform magnetic field, called longitudinal field, oriented along a direction, called longitudinal direction, is established by the primary coil;

b. using all or part of the radio-frequency coils to transmit to said body at least one radio-frequency pulse adapted to excite nuclear spins inside said body;

c. after said or each said radio-frequency pulse, using the gradient coils to apply to said body time-varying magnetic field gradients defining a trajectory in k-space and simultaneously using all or part of the radio-frequency coils to acquire samples of a magnetic resonance signal emitted by the excited nuclear spin, each sample corresponding to a point (KS) of the k-space belonging to said trajectory; and

d. using the signal processing unit) to apply a nonlinear reconstruction algorithm to the acquired samples to reconstruct a magnetic resonance image of said body;

wherein said trajectory in k-space is a continuous trajectory complying with a set of constraints including constraints on maximum amplitude and maximum slew rate of said time-varying magnetic field gradients, such that the points of the k-space corresponding to the samples, called sampling points, define a pseudo-random sampling of the k-space, approximating a predetermined target sampling density, said trajectory in k-space minimizing, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;

characterized in that said trajectory in k-space defines a Cartesian sampling of a central region of the k-space.

Another object of the invention is a computer-implemented method of computing a trajectory in k-space to be used for sample acquisition in magnetic resonance imaging, the method comprising the steps of:

i. determining, or receiving from a user input, a number $N_c \geq 1$ of shots constituting the trajectory and a number $N_s > 1$ of sampling points along each said shot;

ii. determining, or receiving from a user input, a predetermined target sampling density;

iii. determining, or receiving from a user input, a set of constraints including constraints on amplitudes of discrete time derivatives of the trajectory;

iv. computing said trajectory by minimizing, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;

characterized in that said trajectory in k-space defines a Cartesian sampling of a central region of the k-space.

Another object of the invention is a computer program comprising instructions which, when the program is executed by a computer, cause the computer to carry out said method of computing a trajectory in k-space to be used for sample acquisition in magnetic resonance imaging.

Yet another object of the invention is a set of driving signals for gradient coils of a magnetic resonance imaging scanner which, when applied to said gradient coils, drive them to generate time-varying magnetic field gradients defining a trajectory in k-space passing through a plurality of points called sampling points defining a pseudo-random sampling of the k-space, approximating a predetermined target sampling density; wherein said trajectory:

- is continuous and complies with a set of constraints including constraints on maximum amplitude and maximum slew rate of said time-varying magnetic field gradients;
- minimizes, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;

characterized in that said trajectory in k-space defines a Cartesian sampling of a central region of the k-space A further object of the invention is a magnetic resonance imaging scanner comprising:

- a scanner bore inside which a body can be positioned;
- a primary coil configured to establish in the scanner bore a static and substantially uniform magnetic field, called longitudinal field, oriented along a direction, called longitudinal direction;
- radio frequency coils configured to transmit to said body at least one radio-frequency pulse adapted for exciting nuclear spins inside said body and to acquire samples of a magnetic resonance signal emitted by the excited nuclear spin;
- gradient coils configured to apply to said body time-varying magnetic field gradients defining a trajectory in k-space;
- a signal processing unit to apply a nonlinear reconstruction algorithm to the acquired samples of the magnetic resonance signal for reconstructing a magnetic resonance image of said body; and
- a controller configured to generate driving signals for the radio frequency coils and for the gradient coils;

wherein the controller is configured to generate said driving signals for the gradient coils to generate said time-varying magnetic field gradients such that said a trajectory in k-space passes through a plurality of points called sampling points defining a pseudo-random sampling of the k-space, approximating a predetermined target sampling density, said trajectory being continuous and compliant with a set of constraints including constraints on maximum amplitude and maximum slew rate of said time-varying magnetic field gradients, said trajectory in k-space also minimizing, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;
and wherein the controller is also configured to generate driving signals for the radio frequency coils such that they acquire said samples of a magnetic resonance signal emitted by the excited nuclear spin in correspondence to the sampling points of the trajectory in k-space;
characterized in that said trajectory in k-space defines a Cartesian sampling of a central region of the k-space.

Additional features and advantages of the present invention will become apparent from the subsequent description, taken in conjunction with the accompanying drawings, which show:

- Figure 1, the chronogram of a modified GRE (Gradient Recalled Echo) pulse sequence to play implementing a SPARKLING trajectory according to the prior art or a GoLF SPARKLING trajectory according to an embodiment of the invention.
- Figure 2, an exemplary 2D SPARKLING trajectory according to the prior art;
- Figures 3A and 3B, plots illustrating the oversampling of low spatial frequencies obtained using a SPARKLING trajectory according to the prior art;
- Figure 4, an example of GoLF-SPARKLING trajectories according to respective embodiments of the invention;
- Figure 5, MRI images of a test pattern acquired using a 3D SPARKLING k-space trajectory, according to the prior art (left panel) to a 3D GoLF-SPARKLING trajectory according to an embodiment of the invention (right panel), illustrating the technical effect of the invention; and
- Figure 6, a block diagram of a MRI scanner according to an embodiment of the invention.

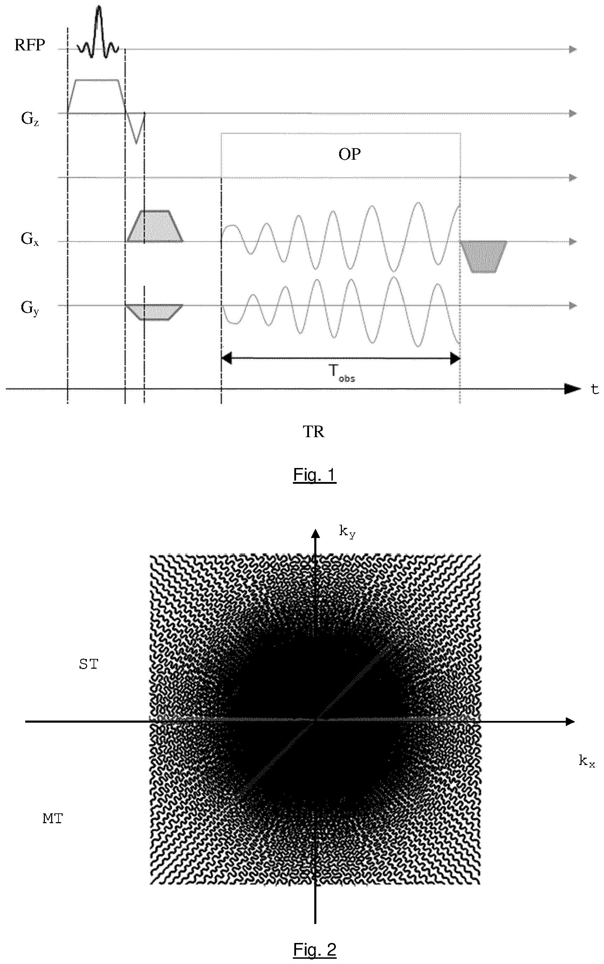

Figure 1 shows the chronogram of a pulse sequence - more particularly a Gradient Recalled Echo (GRE) sequence for T2* weighted anatomical imaging - suitable for implementing either a SPARKLING k-space trajectory according to the prior art or a GoLF-SPARKLING one.

It is supposed that a body to be imaged (e.g. the head of a patient) is placed in a static and homogeneous magnetic field $B_0$ oriented along a "longitudinal" direction z. This magnetic field induces a partial alignment of the spins of the atomic nuclei of the body. The aligned nuclear spins may be excited (i.e. flipped) by a radio-frequency pulse RFP at a suitable frequency (Larmor frequency), depending on the values of the magnetic field $B_0$ and of the magnetic momentum of the nuclei. In 2D sequences, as the one illustrated on the figure, a magnetic field gradient $G_z$ - i.e. a magnetic field oriented along the z direction, whose magnitude varies linearly along this same direction - is also applied. This has the effect of making the Larmor frequency variable along z; as a consequence, only the nuclear spins within a thin slice of the body are resonant with the RF pulse and can be excited. As known in the art of MRI, this "slice selection" gradient pulse is followed by a short negative blip of the $G_z$ magnetic field gradient ("refocusing gradient") which compensates for a dispersion of the nuclear spin orientations in the xy plane, perpendicular to the z direction.

Due to the use of a slice selection gradient $G_z$, only a 2D image of the selected slice of the body is acquired, which requires sampling of a 2D $k_x k_y$ plane of the k-space; in the following, the expression "k-space" will be used to designate both the three-dimensional $k_x k_y k_z$ space and a two-dimensional plane within it. In alternative embodiments, no slice selection gradient is used, and a domain of the 3D $k_x k_y k_z$ space will have to be sampled.

A trajectory in the k-space (more precisely, in the 2D $k_x k_y$ plane) is defined by playing $G_x$ and $G_y$ gradients after the end of the RF excitation pulse. It is important to underline that the applied magnetic field is always oriented along the z direction, but its magnitude shows linear variations along the x and y directions. First of all, $G_x$ and $G_y$ pulses are applied to reach a suitable point on the boundary of the region of the $k_x k_y$ plane to be sampled. Then "arbitrary" $G_x$ and $G_y$ waveforms are played, defining a winding trajectory with an overall radial orientation, directed toward the center of the $k_x k_y$ plane.

In "3D" implementations without slice selection gradient, a $G_z$ waveform similar to $G_x$ and $G_y$ will be applied to reach a suitable point of the boundary of the 3D domain in the $k_x k_y k_z$ space and to define a three-dimensional trajectory in k-space.

While the gradient waveforms are played, samples of the MRI signal emitted by the excited nuclei are acquired by one or more radio-frequency coils connected to a suitable acquisition circuit including an analog-to-digital (ADC) converter. The acquisition period, whose duration $T_{obs}$ is limited by the decay of the MRI signal, is designated by reference OP on figure 1. After the end of the acquisition period, a final $G_x$ gradient pulse ("spoiling gradient") is applied to cancel residual transversal magnetization. The repetition time TR corresponds to the interval beginning just before the radio-frequency pulse RFP and ending at the end of the spoiling gradient pulse.

This sequence is repeated several times with different gradient waveforms defining respective k-space trajectories which, together, provide the required k-space sampling. The ensemble constituted by an excitation RF pulse and the associated gradient waveforms is called a "shot"; each shot corresponds to an elementary trajectory. Figure 2 shows a 2D "multishot" SPARKLING trajectory MT comprising $N_c$=60 radially-oriented elementary trajectories or shots ST, inhomogeneously sampling the $k_x k_y$ plane.

In practice, the magnetic field gradients $G_x$, $G_y$, $G_z$ undergo stepwise changes at discrete time-points separated by intervals of duration $\Delta t$ ("gradient raster time"). Sampling is also performed at regular intervals of duration dt ("ADC dwell time"). The ADC dwell time $\delta t$ is preferably lower than, or at most equal to, the gradient raster time ($\delta t \leq \Delta t$) so as to allow collecting several samples between two consecutive gradient steps. At the same time, reducing the ADC dwell time beyond a certain limit decreases the SNR to an unacceptable level. Therefore, for each specific embodiment of the invention there is an optimal value for $\delta t$ which can be found.

Let $k_i(1)$ the position, in the k-space, of the starting point of the trajectory associated to the $i^{th}$ shot. A first sample of the MRI signal is acquired in correspondence to this point. The other sampling points correspond to k-space positions given by:

$$k_i(m) = k_i(1) + \gamma \left( \sum_{j=1}^{q} G_i(j) * \Delta t + G_i(q+1) * r \right)$$

$$(2)$$

where $m \in [2: M]$ is an integer index, M being the overall number of samples acquired along the trajectory, and a and are respectively the modulus and the rest of the Euclidean division of the acquisition time by :

$$t_{ADC,m} = (m-1) * \delta t = q * \Delta t + r$$

$$(3)$$

If $\delta t = \Delta t$, then r=0 and the number of ADC samples matches the number of gradient time steps. If $\delta t < \Delta t$, then the number of ADC samples is larger than the number of gradient time steps.

"SPARKLING" relies on an optimization-based method that consists of projecting a target sampling distribution over a set of discrete pushforward measures, in particular supported by smooth trajectories [Lazarus et al, 2017; Boyer et al, 2016]. Mathematically, this problem can be cast as a non-convex variational optimization problem under possibly non-convex constraints [Boyer et al, 2016]. The constraints are typical expressed by maximal acceptable values for the gradient amplitude and slew rate, but additional affine constraints may also be used - e.g. imposing that the trajectory passes through a particular point of the k-space at a defined time point (e.g. for echo time definition).

According to ([Boyer et al, 2016], [Lazarus et al. 2017], [Lazarus et al. 2019] and [Chaithya et al. 2022], a SPARKLING trajectory is computed by minimizing, subject to a set of constraints, a cost function defined by the difference between two terms: an "attraction term", which promotes adherence of the distribution of sampling points in k-space to a predetermined (usually non-uniform) target sampling density, and a "repulsion term", promoting separation in k-space between sampling points. This can be written as:

$$\hat{K} = \underset{K \in Q^{Nc}}{argmin} F_p(K) = F_p^a(K) - F_p^r(K)$$

(4)

Where

$$F_p^a(K) = \underset{K \in Q^{Nc}}{argmin} \frac{1}{p} \sum_{i=1}^{p} \int_{\Omega} \|x - K[i]\varrho(x)dx\|$$

(5)

is the attraction term,

$$F_p^r(K) = \frac{1}{2p^2} \sum_{1 \leq i,j \leq p} \|K[i] - K[j]\|$$

(6)

is the repulsion term and:

- N=$N_c \cdot N_s$ is the number of sampling points along the trajectory, $N_c \geq 1$ being the number of shots, or elementary trajectories, constituting the whole trajectory and $N_s > 1$ the number of sampling points of each shot;
- $Q^{Nc}$ is a set of curves in k-space comprising $N_c$ shots, or segments, each comprising $N_s$ points and complying with the constraints;
- $\mathbf{K} = (k_i)_{i=1}^{N_c}$ is the k-space sampling pattern composed of $N_{c=}$ shots $\mathbf{k_i(t)}$;
- $\Omega$ is a sampling region in k-space, normalized to $[-1, 1]^3$ (for 3D trajectories);
- x represents a generic point of the sampling region $\Omega$;
- $\rho$ is said predetermined target sampling density;
- $\|\cdot\|$ is a norm, preferably the $L_2$ norm.

The set of constraints can be defined as follows

$$Q_{A,b}^{N_c} = \left\{ \begin{array}{c} \forall i = 1 \ldots N_c, k_i \in \Omega^{Ns} \\ A_i k_i = \underline{b_i} \\ \|k_i\|_\infty \leq 1, \|\dot{k}_i\|_{2,\infty} \leq \alpha, \|\ddot{k}_i\|_{2,\infty} \leq \beta \end{array} \right\}$$

(7)

where:

- $\dot{k}_i, \ddot{k}_i$ are, respectively, the first and second discretized time derivative of the trajectory in k-space;
- For an arbitrary three-dimensional vector c,

$$\|c\|_{2,\infty} = \sup_{0 \leq n \leq Ns-1} \sqrt{|c_x[n]|^2 + |c_y[n]|^2 + |c_z[n]|^2}$$

;

-

$$A_i = \left(a_{i,1}\middle|a_{i,2}\middle| \dots \middle|a_{i,c_i}\right)^T \in \{0,1\}^{3c_i \times N_s}$$

with

$$a_{i,j} = \begin{bmatrix} a_{i,j}^x[1] & a_{i,j}^y[1] & a_{i,j}^z[1] \\ \vdots & \vdots & \vdots \\ a_{i,j}^x[N_s] & a_{i,j}^y[N_s] & a_{i,j}^z[N_s] \end{bmatrix}$$

and $\underline{b_i} = \left(b_{i,1}, \dots, b_{i,c_i}\right)^T \in \mathbb{R}^{3c_i}$ where je{1, ...c$_i$}, $c_i$ being the number of affine constraints on the i$^{th}$ k-space shot, model the constraints. More precisely, $A_i$ se

- $\alpha$, $\beta$ are normalized parameters expressing hardware constraints on gradient amplitude and gradient slew rate; and

- $\Omega^{Ns}$ represents *Ns* points in $\Omega$

Usually, the trajectory design process starts with an initialization trajectory, formed e.g. by $N_c$ radial spokes, then the optimization problem (4) is solved under constraints (7) by the projected gradient descent algorithm, as discussed in [Chaithya et al. 2020].

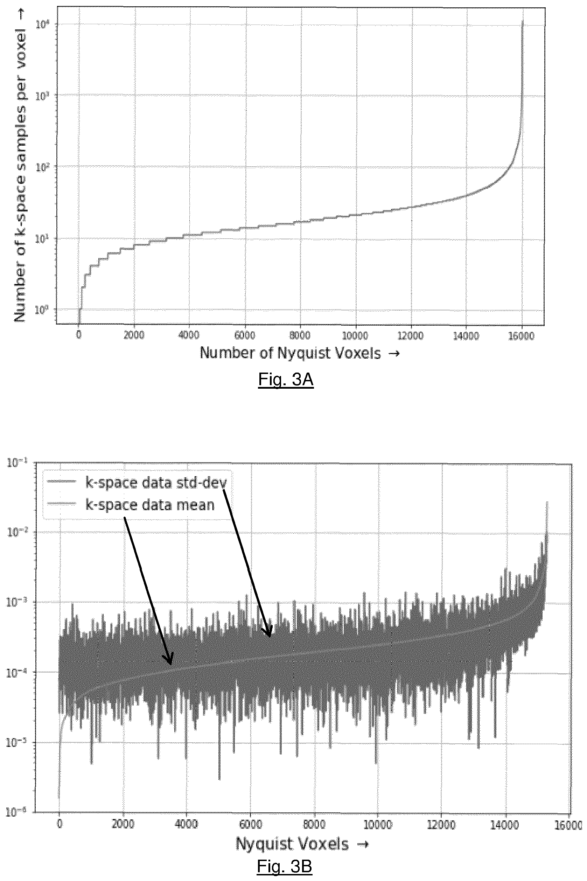

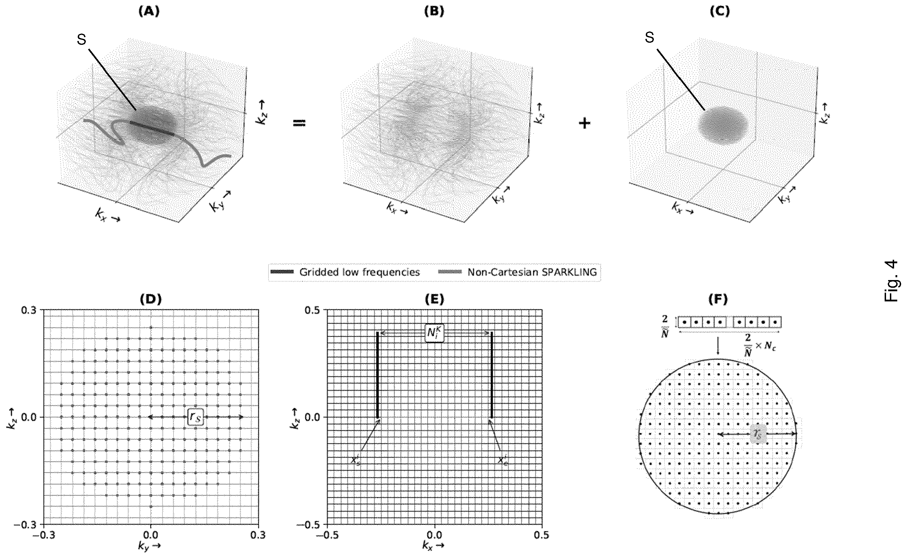

Each individual shot of the trajectory of Figure 2 passes through the center of the k-space, resulting in a sampling of the central (low-frequency) region of this space at a rate much higher than the Nyquist rate. For instance, as illustrated on Figure 3A, with $N_c$=4096, $N_s$=2048 and $\delta t$=2$\mu$s, there are almost 20 k-space samples per Nyquist voxel .

A Nyquist voxel is a voxel defined on the Cartesian grid in k-space, whose size $\Delta k$ =1/FOV with FOV : Field of View in m (e.g. 20cm=0.2m).Collecting a sample per Nyquist voxel allows for linear reconstruction in the central region of k-space without aliasing

As mentioned above, such an oversampling of the low-spatial frequencies is suboptimal as these extra k-space samples could instead be used to sample other higher frequencies. Moreover, as the k-space data are acquired as an integration over different k-space trajectories with different signal amplitude, repeated sampling of the same Nyquist voxels by different trajectories can lead to accumulation of $B_0$ artifacts. This can be seen on Figure 3B, showing the mean and standard deviation of k-space data.

According to the present invention ("GoLF-SPARKLING"), the problem of the low-spatial frequency oversampling is solved by using modified SPARKLING-like trajectories which, in a central region of the k-space, define a Cartesian sampling.

In an exemplary embodiment of the invention, illustrated on figure 4, a sphere S of radius $r_s$ is defined in the center of the k-space. The entire k-space trajectory (panel A of the figure) is split into a non-Cartesian part, for instance a SPARKLING trajectory, outside the sphere (panel B) and a Cartesian part (panel C). In the displayed example $N_c$ = 256 and $N_x = N_y = N_z = \tilde{N}$ = 64. The inner region of the k-space, inside the sphere S, is sampled by straight lines oriented in the $k_x$ direction, which are arranged according to a Cartesian grid in the $k_y k_z$ plane. Panels D and E of figure 4 show cuts of the sphere S according to the $k_y k_z$ and the $k_x k_z$ plane, respectively. The pixel size in of the Cartesian grid in k-space is $2/\tilde{N}$ according to each dimension.

As each k-space shot forms a Cartesian line, the area in the central slice with Cartesian sample circle is given by

$$Area = \pi r_s^2 \cong \left(\frac{2}{\tilde{N}}\right)^2 N_c \tag{8}$$

from which one obtains

$$r_s = \frac{2}{\tilde{N}} \left\lceil \sqrt{\frac{N_c}{\pi}} \right\rceil \tag{9}$$

Based on the Nyquist criteria, it is then necessary to sample at least every $\Delta k_x = \frac{2}{\tilde{N}}$ to have non-aliased reconstructed images. However, as the k-space data is sampled at every dwell time $\delta t < \Delta t$, in practice, the scanner can play k-space trajectory to take at least $\frac{\Delta k_x \Delta t}{\delta t}$ at every $\Delta t$. Generalizing this, it is possible to introduce k-space velocity at center of k-space as a dimensionless parameter $v \geq 0$, which is the number of Nyquist voxel steps $\Delta k_x$ taken in the readout direction $k_x$ per gradient raster time $\Delta t$. Particularly, k-space trajectory takes steps of size $v \Delta k_x < \frac{\Delta k_x \Delta t}{\delta t}$ at every $\Delta t$. The purpose of $v$ is to efficiently utilize the gradient hardware in traversing the center of k-space at maximum feasible speed while maintaining Nyquist criteria after sampling at ADC at every $\delta t$. Taking a high value of $v$ improves the k-space coverage, but can lower the signal-to-noise ratio as the MR signal is accumulated over a shorter time interval. Therefore, a tradeoff is needed. For instance, for $T_2^*$ imaging at 3T, $v \leq 1$ is preferred.

If, without loss of generality, it is assumed that the Cartesian portion of the i$^{th}$ k-space shot $\mathbf{k_i}$ starts as a k-space line at $x_i^s$ and ends at $x_i^e$ (see the panel E of figure 4), then the number of sample at the center of the k-space (i.e. inside the sphere S) of this shot is given by

$$N_i^K = \left\lceil \frac{x_i^e - x_i^s}{v \Delta k_x} \right\rceil \tag{10}$$

The k-space locations of these Nyquist points are given by

$$x_i^\ell = x_i^s + \frac{\ell\left(x_i^e - x_i^s\right)}{N_i^K} \quad \forall \ell \in \{1 \dots N_i^K\} \tag{11}$$

This results in $c_i = N_i^K$ constraints which are applied to the i$^{th}$ space shot $\mathbf{k_i}$ at $N_i^K$ indices between $k_i^L = \left\lceil \frac{N_c - N_i^K}{2} \right\rceil$ and $k_i^L = \left\lceil \frac{N_c + N_i^K}{2} \right\rceil$ where "L" and "H" stand for "low" and "high" respectively. The constraints are then expressed by:

$$a_{i,j}^d[k] = \begin{cases} 1 \text{ for } k = k_i^L + j \; ; \; j \in \{1, \dots, c_i\}; \; i \in \{1, \dots, N_c\}; d\{x,y,z\} \\ 0 \text{ otherwise} \end{cases} \tag{12}$$

$$b_{i,\ell} = x_i^\ell \forall \ell \in \{1 \dots N_i^K\} \tag{13}$$

The set of affine constraints of equations (12) and (13) allows performing Cartesian sampling of a central region of k-space S. In order to enforce that said Cartesian sampling is performed at the Nyquist rate, however, a suitable target sampling density (TSD) has to be chosen, which is different in the central region of the k-space and outside it.

Let us consider a normalized sampling domain $\Omega=[-1, 1]^3$. According to an exemplary embodiment, the target sampling density can be parameterized with cutoff C and decay D as follows:

$$\Pi_{r_s,D}(x) = \begin{cases} \kappa_1 & |x| < r_s \\ \kappa_2 \left(\frac{r_s}{|x|}\right)^D & |x| > r_s \end{cases} \tag{14}$$

If $N=N_c\times N_S$ is the total number of sampling points, the number of samples in the central region S of k space defined by $|x| < r_s$ is

$$N_{|x|<r_s} = N\kappa_1 \frac{4}{3}\pi r_s^3 \tag{15}$$

Additionally, the number of Nyquist points in the central region of the k-space is given by

$$N_{Nyq} = \frac{\frac{4}{3}\pi r_s^3}{\Delta k_x^3} \tag{16}$$

If the trajectory velocity, defined above, is given by v, then there are $\frac{N_{Nyq}}{v}$ in the central region of the k-space. From the previous equations, one obtains:

$$N_{|x|<r_s} = \frac{N_{Nyq}}{v}$$

$$N\kappa_1 \frac{4}{3}\pi r_s^3 = \frac{\frac{4}{3}\pi r_s^3}{v\Delta k_x^3}$$

$$\kappa_1 = \frac{1}{vN\Delta k_x^3} \tag{17}$$

The ratio of number of Nyquist samples with non-Cartesian sampling ($N^{nc}$) and with Cartesian sampling ($N^c$) is given by the inverse of the ratio of the corresponding volumes:

$$\frac{N^{nc}}{N^c} = \frac{\Delta k_x^3}{\frac{4}{3}\pi\left(\frac{\Delta k_x}{2}\right)^2} = \frac{6}{\pi} \tag{18}$$

From (18), and taking into account that the density needed for Cartesian sampling is $v\kappa_1$, one finds

$$\kappa_2 = v\kappa_1 \frac{N^{nc}}{N^c} = v\kappa_1 \frac{6}{\pi} \tag{19}$$

However, in practice one cannot achieve Poisson disk sampling due to constraints on speed and acceleration of the trajectory. To prevent any k-space hole, it is preferred to sample the non-Cartesian region at 1.5 times the Nyquist period, therefore taking

$$\kappa_2 = vv\kappa_1 \frac{9}{\pi} \tag{20}$$

Finally, as $\Pi_{r_s},D(x)$ is a distribution, it has to be normalized, therefore its sum must be equal to 1:

$$\int_0^1 \int_0^{2\pi} \int_0^\pi \Pi_{r_s,D}(x)x^2 sin\theta d\theta d\phi dx = 1$$

$$4\pi \int_0^1 \Pi_{r_s,D}(x)\, x^2 dx = 1$$

$$4\pi \left( \int_0^{r_s} \kappa_1 x^2 dx + \int_{r_s}^1 \kappa_2 \left( \frac{r_s}{|x|} \right)^D x^2 dx \right) = 1$$

$$4\pi \left( \frac{\kappa_1 r_s^3}{3} + \kappa_2 \frac{(r_s)^D - r_s^3}{3-D} \right) = 1 \tag{21}$$

By replacing (19) and (20) into (21), one can solve iteratively for D.

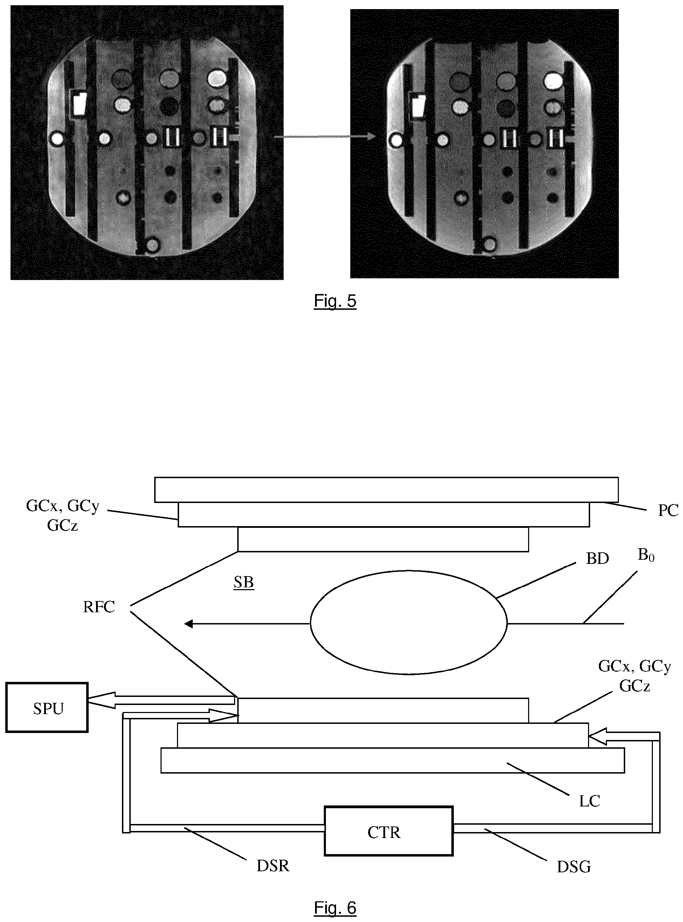

A comparison between the left panel of Figure 5 (MRI image of a test pattern obtained using prior art SPARKLING trajectories) and its right panel (MRI image of the same pattern obtained using GoLF-SPARKLING trajectories) show that the invention allows obtaining a substantially better flat contrast.

Figure 6 illustrates, very schematically, an apparatus for carrying out a method according to the invention. This apparatus is basically a MRI scanner comprising a primary coil PC for generating the longitudinal field $B_0$, a single or preferably a plurality of radio-frequency coils TC for generating RF pulses and receiving the MRI signal (different radio-frequency coils may be used for transmission and reception, or the same coils may serve for both purposes), three gradient coils GCx, GCy and GCz for generating magnetic field gradients $G_x$, $G_y$, $G_z$ along the x, y and z axes respectively (not represented). The gradient coils are disposed around a scanner bore SB in which a body BD to be imaged can be introduced. The term "body" should be construed broadly, designating any living or non-living object containing atomic nuclei at least some of which are supposed to have nonzero spin. For instance, body BD may be a human or animal body or a portion thereof (e.g. a head) or an article of manufacture such as a "phantom". The apparatus also comprises a control unit CTR for driving said gradient coils in and said radio-frequency coil or coils according to a predetermined driving signals (reference DSR for the radio-frequency coils and DSG for the gradient coils) to implement a readout sequence (see e.g. figure 1) and a k-space trajectory of the GoLF-SPARKLING type. The apparatus also comprises a signal processing unit SPU for acquiring MRI signals from the radio-frequency coil or coils and performing image reconstruction. The control unit and the signal processing unit may be separate devices or a single device may implement both functions. Said device or devices may include one or more suitably programmed general purpose computers or digital signal processors, suitably configured specialized digital circuits or both. The signal processing unit also includes a receiving circuit for acquiring MRI signals, comprising a signal amplifier, a sampler and an analog to digital (ADC) converter.

The scanner of figure 9 differs from the prior art essentially in that the controlling unit CTR is configured or programmed for driving the gradient coils in such a way that they define a GoLF-SPARKLING k-space trajectory. For instance, a driving signal DRG defining a GoLF-SPARKLING trajectory may be stored in a memory of said controlling unit.

The invention has been described with reference to specific examples, but is not limited to them. For instance, the predetermined sampling density may be different from that expressed by equations (14) - (21).

The invention applies to 3D imaging, but also to 2D multislice k-space sampling and to 4D imaging where acceleration can be largely increased.

Trajectory optimization can be initialized starting from any classic k-space filling support (including Cartesian lines, spirals, radial, ...), not only radial spokes as in the exemplary embodiments.

The shape of the central region of k-space where sampling is Cartesian needs not be spherical or ellipsoidal, even if these constitute preferred embodiments. It can have other shapes, e.g. that of a cube or a rectangular cuboid.

The inventive method may be adapted to any types of MR readout scheme segmented or single-shot, from GRE (cf. the detailed examples above), Turbo FLASH (also called MPRAGE for brain applications) to Spin Echo (SE) or Turbo Spin Echo (TSE), TrueFisp (also called bSSFP), EPI.

It may also be adapted to any types of MR sequence weighting T1, T2, T2*, $\rho$ (Spin Density), fMRI (functional MRI) or BOLD MRI, and preparation including none-exhaustively, ASL (Arterial Spin Labelling), DWI (Diffusion weighting imaging) with all its variants (DTI, DSI, IVIM, Kurtosis, NODDI), MTR (Magnetization Transfer Ratio) of any type including CEST, quantitative MRI including simultaneous multiparametric techniques such as Quantitative Susceptibility Mapping (QSM), MRF (MR Fingerprinting), MR Angiography both static or dynamic. This includes more exotic MRI applications such as MR thermometry or Electromagnetic Property Tomography (EPT). It may also be applied to heteronuclear imaging such as Sodium or Phosphorus.

It is compatible with parallel imaging using coil phased array and Simultaneous Multislice technique.

It is also compatible with the MORE-SPARKLING technique, described in European Patent Application 22305592.2 filed by the applicant on 21 April 2022. This technique modifies the SPARKLING repulsion term by introducing in each individual term a weight W which increase with the temporal separation $|t_i - t_j|$ of the sampling points along the trajectory in k-space:

$$F_p^r(K) = \frac{1}{2p^2} \sum_{1 \leq i,j \leq p} W\left(|t_i - t_j|\right) \|K[i] - K[j]\| \qquad (22)$$

Preferably, W is an exponential function of $|t_i - t_j|$:

$$W\left(|t_i - t_j|\right) = exp\left(\frac{|t_i - t_j|\tau}{p}\right) \qquad (23)$$

where $\tau \geq 1$ is a scalar parameter.

The weight W ensure that the resulting k-space trajectories are temporally homogeneous - i.e. that regions of the k-space that are close to each other are sampled at close times. The value of parameter $\tau$ has to be chosen (e.g. by grid-searching) to enforce temporally smooth k-space sampling, while avoiding undesirable k-space holes. Combining MORE-SPARKLING and GoLF-SPARKLING does not pose any specific difficulty because the first modify the cost function of the SPARKLING trajectory-design algorithm and the second the affine constraints onto which the trajectories are projected and the TSD.

According to a different embodiment, Cartesian sampling can be performed in one or more regions of the k-space, other than a central region thereof.

References

[Andersson et al. 2003] J.L.R. Andersson, S. Skare, J. Ashburner "How to correct susceptibility distortions in spin-echo echo-planar images: application to diffusion tensor imaging". NeuroImage, 20(2):870-888, 2003.

[Boyer et al, 2016] Boyer, Claire, et al. "On the generation of sampling schemes for magnetic resonance imaging." SIAM Journal on Imaging Sciences 9.4 (2016): 2039-2072.

[Chaithya et al. 2020] Chaithya G R et al. "Optimizing full 3D SPARKLING trajectories for high-resolution T2*-weighted MagneticResonance Imaging. 2020 arXiv preprint arXiv:2108.02991.

[Chauffert et al. 2016] Chauffert, Nicolas et al. "A projection algorithm for gradient waveforms design" in Magnetic Resonance Imaging. IEEE Transactions on Medical Imaging, Institute of Electrical and Electronics Engineers, 2016, 35 (9), pp.2026-2039.

[Daval-Frerot et al. 2021] Daval-Frérot, Guillaume "Off-resonance correction of non-Cartesian SWI using internal field map estimation" International Society for Magnetic Resonance in Medicine, May 2021, Online, United States.

[Haldar, 2014] Haldar, Justin P. "Low-Rank Modeling of Local k-Space Neighborhoods (LORAKS) for Constrained MRI", IEEE Transactiojn of Medical Imaging 33.3 (2014): 668 - 680.

[Lazarus et al, 2017] Lazarus, Carole, et al. "SPARKLING: Novel Non-Cartesian Sampling Schemes for Accelerated 2D Anatomical Imaging at 7T Using Compressed Sensing." 25th annual meeting of the International Society for Magnetic Resonance Imaging, Apr 2017, Honolulu, United States.

[Lazarus 2019] Lazarus, Carole et al. "SPARKLING: variable-density k-space filling curves for accelerated T 2 * - weighted MRI" Magnetic Resonance in Medicine, Wiley, 2019, 81 (6), pp.3643-3661.

[Lustig et al, 2007] Lustig M., Donoho D., Pauly J. M. Sparse MRI: The application of compressed sensing for rapid MR imaging. Magn Reson Med 2007; 58: 1182-1195

[Sutton et al. 2003] Sutton, Bradley P, et al."Iterative Image Reconstruction for MRI in the Presence of Field Inhomogeneities". IEEE Transactions on Medical Imaging 2003;22 (2): 178-88.

**Claims**

1. A method of performing magnetic resonance imaging of a body using a magnetic resonance imaging scanner comprising a scanner bore (SB), a primary coil (PC), radio frequency coils (RFC), gradient coils ($GC_x$, $GC_y$, $GC_z$) and a signal-processing unit (SPU), the method comprising the steps of:

    a. positioning the body (BD) in a scanner bore (SB) where a static and substantially uniform magnetic field ($B_0$), called longitudinal field, oriented along a direction (z), called longitudinal direction, is established by the primary coil (PC);
    b. using all or part of the radio-frequency coils (RFC) to transmit to said body at least one radio-frequency pulse (RFP) adapted to excite nuclear spins inside said body;
    c. after said or each said radio-frequency pulse, using the gradient coils ($GC_x$, $GC_y$, $GC_z$) to apply to said body time-varying magnetic field gradients ($G_x$, $G_y$, $G_z$) defining a trajectory (ST) in k-space and simultaneously using all or part of the radio-frequency coils to acquire samples of a magnetic resonance signal emitted by the excited nuclear spin, each sample corresponding to a point (KS) of the k-space belonging to said trajectory; and
    d. using the signal processing unit (SPU) to apply a nonlinear reconstruction algorithm to the acquired samples to reconstruct a magnetic resonance image of said body;
    wherein said trajectory (ST, MT) in k-space is a continuous trajectory complying with a set of constraints including constraints on maximum amplitude and maximum slew rate of said time-varying magnetic field gradients, such that the points (KS) of the k-space corresponding to the samples, called sampling points, define a pseudo-random sampling of the k-space, approximating a predetermined target sampling density, said trajectory in k-space minimizing, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;
    **characterized in that** said trajectory (ST, MT) in k-space defines a Cartesian sampling of a central region (S) of the k-space.

2. The method of claim 1 wherein said set of constraints comprise a affine constraint imposing said Cartesian sampling of said central region (S) of the k-space.

3. The method of any one of the preceding claims wherein said central regions (S) of the k-space has a spherical or ellipsoidal shape.

4. The method of any one of the preceding claims wherein the predetermined target sampling density is such that said trajectory is suitable for sampling said central region of the k-space at a rate comprised between the Nyquist rate and 1.5 times the Nyquist rate.

5. The method of any one of the preceding claims wherein said attraction term is defined by

$$F_p^a(K) = \underset{K \in Q^{Nc}}{argmin}\, \frac{1}{p}\sum_{i=1}^{p} \int_{\Omega} \|x - K[i]\varrho(x)dx\|$$

and said repulsion term is defined by

$$F_p^r(K) = \frac{1}{2p^2} \sum_{1 \le i,j \le p} W\big(|t_i - t_j|\big)\|K[i] - K[j]\|$$

where:

    - **K** is a two or three dimensional vector representing the coordinates of a sampling point in k-space;
    - $N = N_c \cdot N_s$ is the number of sampling points along the trajectory, each trajectory being constituted of $N_c \ge 1$ shots

each comprising $N_s > 1$ sampling points;
- $Q^{Nc}$ is a set of curves in k-space comprising $N_c$ segments of $N_s$ points each and complying with said constraints;
- $\Omega$ is a sampling region in k-space;
- x represents a generic point of the sampling region $\Omega$;
- $\rho$ is said predetermined target sampling density;
- $\|\cdot\|$ is a norm;
- $t_i$, $t_j$ are the times at which two sampling points of a same shot, identified by integer indices i and j, are reached; and
- W is a monotonously increasing function of $|t_i - t_j|$ expressing said weight.

6. The method of any one of the preceding claims further comprising a preliminary step of computing said trajectory (ST) in k-space.

7. A computer-implemented method of computing a trajectory in k-space to be used for sample acquisition in magnetic resonance imaging, the method comprising the steps of:

    i. determining, or receiving from a user input, a number $N_c \geq 1$ of shots constituting the trajectory and a number $N_s > 1$ of sampling points along each said shot;
    ii. determining, or receiving from a user input, a predetermined target sampling density;
    iii. determining, or receiving from a user input, a set of constraints including constraints on amplitudes of discrete time derivatives of the trajectory;
    iv. computing said trajectory by minimizing, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;

    **characterized in that** said trajectory (ST, MT) in k-space defines a Cartesian sampling of a central region (S) of the k-space.

8. The method of claim 7 wherein said set of constraints comprise a affine constraint imposing said Cartesian sampling of said central region (S) of the k-space.

9. The method of claim 8 wherein said central regions (S) of the k-space has a spherical or ellipsoidal shape.

10. The method of any one of the claims 7 to 9 wherein the predetermined target sampling density is such that said trajectory is suitable for sampling said central region of the k-space at a rate comprised between the Nyquist rate and 1.5 times the Nyquist rate.

11. The method of of any one of the claims 7 to 10 wherein said attraction term is defined by

$$F_p^a(K) = \underset{K \in Q^{Nc}}{arg\,min} \frac{1}{p} \sum_{i=1}^{p} \int_\Omega \|x - K[i]\varrho(x)dx\|$$

and said repulsion term is defined by

$$F_p^r(K) = \frac{1}{2p^2} \sum_{1 \leq i,j \leq p} W\big(|t_i - t_j|\big) \|K[i] - K[j]\|$$

where:

- **K** is a two or three dimensional vector representing the coordinates of a sampling point in k-space;
- $N = N_c \cdot N_s$ is the number of sampling points along the trajectory;

- $Q^{Nc}$ is a set of curves in k-space comprising $N_c$ segments of $N_s$ points each and complying with said constraints;
- $\Omega$ is a normalized sampling region in k-space;
- x represents a generic point of the sampling region $\Omega$;
- $\rho$ is said predetermined target sampling density;
- $\|\cdot\|$ is a norm;
- $t_i$, $t_j$ are the times at which two sampling points of a same shot, identified by integer indices i and j, are reached; and
- W is a monotonously increasing function of $|t_i - t_j|$ expressing said weight.

12. A computer program comprising instructions which, when the program is executed by a computer, cause the computer to carry out the method of any one of claims 7 to 11.

13. A set of driving signals (DSG) for gradient coils of a magnetic resonance imaging scanner which, when applied to said gradient coils, drive them to generate time-varying magnetic field gradients ($G_x$, $G_y$, $G_z$) defining a trajectory (ST, MT) in k-space passing through a plurality of points (KS) called sampling points defining a pseudo-random sampling of the k-space, approximating a predetermined target sampling density; wherein said trajectory:

- is continuous and complies with a set of constraints including constraints on maximum amplitude and maximum slew rate of said time-varying magnetic field gradients;
- minimizes, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;

**characterized in that** said trajectory (ST, MT) in k-space defines a Cartesian sampling of a central region (S) of the k-space.

14. A magnetic resonance imaging scanner comprising:

- a scanner bore (SB) inside which a body can be positioned;
- a primary coil (PC) configured to establish in the scanner bore a static and substantially uniform magnetic field ($B_0$), called longitudinal field, oriented along a direction (z), called longitudinal direction;
- radio frequency coils (RFC) configured to transmit to said body at least one radio-frequency pulse (RFP) adapted for exciting nuclear spins inside said body and to acquire samples of a magnetic resonance signal emitted by the excited nuclear spin;
- gradient coils ($GC_x$, $GC_y$, $GC_z$) configured to apply to said body time-varying magnetic field gradients ($G_x$, $G_y$, $G_z$) defining a trajectory (ST, MT) in k-space;
- a signal processing unit (SPU) to apply a nonlinear reconstruction algorithm to the acquired samples of the magnetic resonance signal for reconstructing a magnetic resonance image of said body; and
- a controller (CTR) configured to generate driving signals (DSR) for the radio frequency coils and (DSG) for the gradient coils;
wherein the controller is configured to generate said driving signals for (DSG) for the gradient coils to generate a said time-varying magnetic field gradients ($G_x$, $G_y$, $G_z$) such that said a trajectory (ST) in k-space passes through a plurality of points (KS) called sampling points defining a pseudo-random sampling of the k-space, approximating a predetermined target sampling density, said trajectory being continuous and compliant with a set of constraints including constraints on maximum amplitude and maximum slew rate of said time-varying magnetic field gradients, said trajectory in k-space also minimizing, subject to said set of constraints, a cost function defined by the difference between a first term, called attraction term, promoting adherence of the distribution of sampling points in k-space to said predetermined target sampling density, and a second term, called repulsion term, promoting separation in k-space between sampling points, said repulsion term being expressed as a sum of contributions corresponding to respective pairs of sampling points;
and wherein the controller is also configured to generate driving signals (DSR) for the radio frequency coils such that they acquire said samples of a magnetic resonance signal emitted by the excited nuclear spin in correspondence to the sampling points (KS) of the trajectory in k-space;
**characterized in that** said trajectory (ST, MT) in k-space defines a Cartesian sampling of a central region (S) of the k-space.

Fig. 1

Fig. 2

Fig. 3A

Fig. 3B

Fig. 4

Fig. 5

Fig. 6

Europäisches
Patentamt

European
Patent Office

Office européen
des brevets

# EUROPEAN SEARCH REPORT

**Application Number**

EP 23 30 5808

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHAITHYA G R ET AL: "MORE-SPARKLING: Non-Cartesian trajectories with Minimized Off-Resonance Effects", PROCEEDINGS OF THE JOINT ANNUAL MEETING ISMRM-ESMRMB 2022 & ISMRT ANNUAL MEETING, LONDON, UK, 07-12 MAY 2022, ISMRM, 2030 ADDISON STREET, 7TH FLOOR, BERKELEY, CA 94704 USA, no. 1611, 22 April 2022 (2022-04-22), XP040728159, * page 1 - page 2; figure 1 * | 1-14 | INV. G01R33/48 |
| X | CHAITHYA G R ET AL: "Optimizing full 3D SPARKLING trajectories for high-resolution T2*-weighted Magnetic Resonance Imaging", ARXIV.ORG, CORNELL UNIVERSITY LIBRARY, 201 OLIN LIBRARY CORNELL UNIVERSITY ITHACA, NY 14853, 6 August 2021 (2021-08-06), XP091028772, | 1-4, 6-10, 12-14 | |
| A | * page 3 * | 5,11 | |
| A | US 2022/326329 A1 (DONG FANG [CN] ET AL) 13 October 2022 (2022-10-13) * the whole document * | 1-14 | **TECHNICAL FIELDS SEARCHED (IPC)** G01R |
| A | US 2019/195975 A1 (LIU HUI [US] ET AL) 27 June 2019 (2019-06-27) * paragraph [0189] - paragraph [0223]; figure 15 * | 1-14 | |

The present search report has been drawn up for all claims

| Place of search | Date of completion of the search | Examiner |
|---|---|---|
| Munich | 3 November 2023 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 30 5808

This annex lists the patent family members relating to the patent documents cited in the above-mentioned European search report.
The members are as contained in the European Patent Office EDP file on
The European Patent Office is in no way liable for these particulars which are merely given for the purpose of information.

03-11-2023

| Patent document cited in search report | | Publication date | Patent family member(s) | | Publication date |
|---|---|---|---|---|---|
| US 2022326329 | A1 | 13-10-2022 | CN | 115201731 A | 18-10-2022 |
| | | | US | 2022326329 A1 | 13-10-2022 |
| US 2019195975 | A1 | 27-06-2019 | CN | 109581253 A | 05-04-2019 |
| | | | CN | 112881957 A | 01-06-2021 |
| | | | US | 2019195975 A1 | 27-06-2019 |

EPO FORM P0459

For more details about this annex : see Official Journal of the European Patent Office, No. 12/82

## REFERENCES CITED IN THE DESCRIPTION

**Patent documents cited in the description**

- WO 2019048565 A

- EP 22305592

**Non-patent literature cited in the description**

- **J.L.R. ANDERSSON ; S. SKARE ; J. ASHBURN-ER.** How to correct susceptibility distortions in spin-echo echo-planar images: application to diffusion tensor imaging. *NeuroImage,* 2003, vol. 20 (2), 870-888
- **BOYER, CLAIRE et al.** On the generation of sampling schemes for magnetic resonance imaging. *SIAM Journal on Imaging Sciences,* 2016, vol. 9 (4), 2039-2072
- **CHAITHYA G R et al.** Optimizing full 3D SPARKLING trajectories for high-resolution T2*-weighted MagneticResonance Imaging. *arXiv:2108.02991,* 2020
- **CHAUFFERT, NICOLAS et al.** A projection algorithm for gradient waveforms design. *Magnetic Resonance Imaging. IEEE Transactions on Medical Imaging, Institute of Electrical and Electronics Engineers,* 2016, vol. 35 (9), 2026-2039
- **DAVAL-FRÉROT, GUILLAUME.** Off-resonance correction of non-Cartesian SWI using internal field map estimation. *International Society for Magnetic Resonance in Medicine,* May 2021
- **HALDAR, JUSTIN P.** Low-Rank Modeling of Local k-Space Neighborhoods (LORAKS) for Constrained MRI. *IEEE Transactiojn of Medical Imaging,* 2014, vol. 33 (3), 668-680
- **LAZARUS, CAROLE et al.** SPARKLING: Novel Non-Cartesian Sampling Schemes for Accelerated 2D Anatomical Imaging at 7T Using Compressed Sensing. *25th annual meeting of the International Society for Magnetic Resonance Imaging,* April 2017
- SPARKLING: variable-density k-space filling curves for accelerated T 2 * - weighted MRI. **LAZARUS, CAROLE et al.** Magnetic Resonance in Medicine. Wiley, 2019, vol. 81, 3643-3661
- **LUSTIG M. ; DONOHO D. ; PAULY J. M.** Sparse MRI: The application of compressed sensing for rapid MR imaging. *Magn Reson Med,* 2007, vol. 58, 1182-1195
- **SUTTON, BRADLEY P et al.** Iterative Image Reconstruction for MRI in the Presence of Field Inhomogeneities. *IEEE Transactions on Medical Imaging,* 2003, vol. 22 (2), 178-88